# EUROPEAN PATENT APPLICATION

(11) **EP 4 636 821 A1**
(43) Date of publication of application: **22.10.2025**
(21) Application number: 22968407.1
(22) Date of filing: 13.12.2022
(51) Int. Cl.: H01L 23/02, H05K 9/00

(54) **PACKAGE**

(71) Applicant: NTT, Inc., Tokyo 100-8116 (JP)
(72) Inventor: WAKITA, Hitoshi, Musashino-shi, Tokyo 180-8585 (JP); NAGATANI, Munehiko, Musashino-shi, Tokyo 180-8585 (JP); TAKAHASHI, Hiroyuki, Musashino-shi, Tokyo 180-8585 (JP); TAKEYA, Tsutomu, Musashino-shi, Tokyo 180-8585 (JP); JO, Teruo, Musashino-shi, Tokyo 180-8585 (JP)
(74) Representative: Samson & Partner Patentanwälte mbB
(86) International application number: PCT/JP2022/045831
(87) International publication number: WO 2024/127495

(57) **Abstract**

The package includes a container (101), an engaging section (103), a dielectric substrate (105), an input/output IF (106), a radio wave absorber (107) and a lid (108). The container (101) includes an engaging section (103) formed by a step extending to an outer peripheral side and formed at an opening edge (102), and the radio wave absorber (107) is engaged to the engaging section (103) to cover a whole region of a bottom surface (104) of the container (101).

## Description

### [Technical Field]

The present invention relates to a package in which a device with broadband characteristics is accommodated.

### [Background Art]

In recent years, the amount of data transmitted over communication networks has been increasing, and technique for improving the transmission rate of data have been researched and developed to cope with the increase in the amount of data. This tendency is the same in optical communication systems, and a wide band is required for each device that constitutes a transceiver in an optical communication system for high speed. Similarly, broadband characteristics are required with regard to measuring instruments that measure devices with broadband characteristics. These devices often include a compound semiconductor such as InP, an amplifier is adopted for an electric device, and an optical package is adopted for an optical device, as an example. In the devices (compound-based devices) including these compound semiconductors, it is desirable for a package in which the devices are accommodated to be hermetically sealed to ensure reliability.

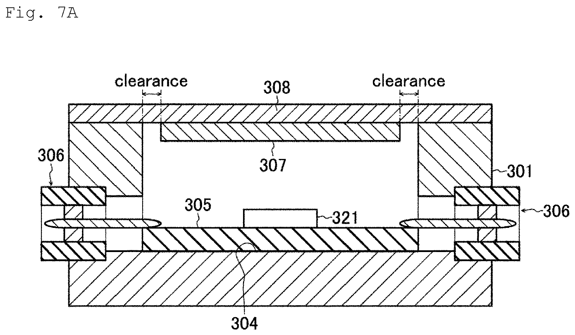

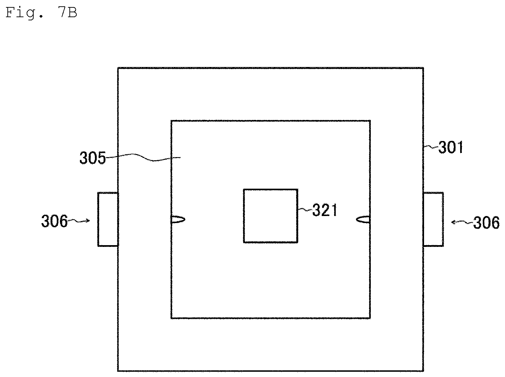

A typical package will be described with reference to Figs. 7A and 7B. The package of this type includes a bottomed container 301 made of a metal and having an open top surface, a dielectric substrate 305 disposed on a bottom 304 of the bottomed container 301 and on which a device 321 is mounted, an input/output IF 306 connected to the device 321 provided on a side surface of the bottomed container 301, and a lid 308 made of a metal that closes the open end of the bottomed container 301 and seals the inside of the bottomed container 301. The inside of the bottomed container 301 is hermetically sealed by the lid 308. For sealing the lid 308, for example, a sealing technique such as seam welding is used.

However, it is known that in the above-mentioned package technique, the frequency characteristic deteriorates due to cavity resonance of the package, and the device operation accommodated in the package becomes unstable.

As a technique for suppressing the cavity resonance described above, NPL 1 and PTL 1 describe techniques for absorbing unnecessary electromagnetic radiation by bonding a radio wave absorber 307 to the lid 308. Both have a structure in which the radio wave absorber 307 is joined to the inside surface of the container of the lid 308, and the radio wave absorber 307 absorbs unnecessary electromagnetic waves to suppress cavity resonance.

### [Citation List]

### [Patent Literature]

[PTL 1] Japanese Patent Application Publication No. H08-018310

### [Non Patent Literature]

[NPL 1] N. Iwasaki et al., "WIDEBAND PACKAGE USING AN ELECTROMAGNETIC ABSORBER", Electronics Letters, vol 29, No. 10, pp. 875-876, 1993.

### [Summary of Invention]

### [Technical Problem]

However, when the lid 308 is seam-sealed to the bottomed container 301 to hermetically seal the inner cavity of the package, there is a concern of the inner wall of the bottomed container 301 interfering with the radio wave absorber 307, in which case the radio wave absorber 307 may be broken, or of the radio wave absorber 307 and the bottomed container 301 interfering with each other to ensure airtightness. Therefore, the radio wave absorber 307 needs to be joined to the inner wall of the bottomed container 301 with a certain clearance.

By providing a certain clearance between the radio wave absorber 307 and the inner wall of the bottomed container 301 in this manner, airtightness of the package inner cavity can be secured, but the whole upper surface of the package inner cavity (cavity) cannot be covered with the radio wave absorber 307. The inner surface of the lid 308 is exposed at the clearance portion. In such a state, the effect of the radio wave absorption of the radio wave absorber 307 is weakened, and as a result, there is a problem that cavity resonance cannot be completely suppressed.

The present invention has been made to solve the problem described above and an object thereof is to cover the entire upper surface of the package inner cavity with a radio wave absorber, while ensuring the airtightness of the package inner cavity.

### [Solution to Problem]

A package according to the present invention includes
a bottomed cylindrical container having an open upper surface, the container being made of a metal; an engaging section provided by a step formed on an opening edge of the container and extending toward an outer peripheral side; a dielectric substrate disposed on a bottom surface of the container, the dielectric substrate on which a device is mounted; an
input/output IF provided on a side surface of the container and connected to the device; a plate-like radio wave absorber engaged to the engaging section so as to cover a whole region of the bottom surface of the container; and a lid made of a metal which closes an opening end of the container and seals the inside of the container.

### [Advantageous Effects of Invention]

As described above, according to the present invention, since the engaging section constituted by the step extending to the outer peripheral side is formed at the opening edge of the container and the radio wave absorber is engaged to the engaging section, the entire upper surface of the package inner cavity can be covered with the radio wave absorber, after ensuring the airtightness of the package cavity.

### [Brief Description of Drawings]

[Fig. 1A] Fig. 1A is a cross-sectional view showing a configuration of a package according to Embodiment 1 of the present invention.
[Fig. 1B] Fig. 1B is a plan view showing a partial configuration of the package according to Embodiment 1 of the present invention.
[Fig. 2] Fig. 2 is a cross-sectional view showing a configuration of a package according to Embodiment 2 of the present invention.
[Fig. 3] Fig. 3 is a cross-sectional view showing a configuration of a package according to Embodiment 3 of the present invention.
[Fig. 4] Fig. 4 is a cross-sectional view showing a configuration of a package according to Embodiment 4 of the present invention.
[Fig. 5A] Fig. 5A is a cross-sectional view showing a configuration of a package according to Embodiment 5 of the present invention.
[Fig. 5B] Fig. 5B is a plan view showing a partial configuration of the package according to Embodiment 5 of the present invention.

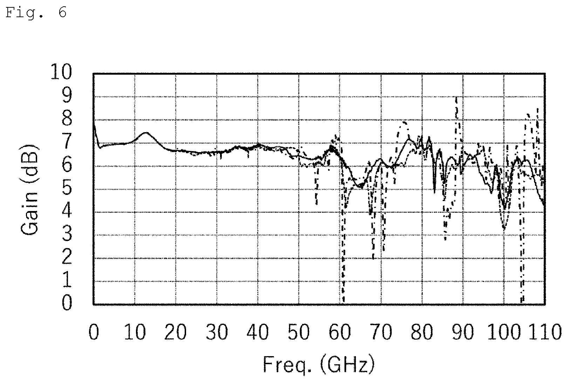

[Fig. 6] Fig. 6 is a characteristic diagram showing the state of cavity resonance in the package according to Embodiment 1 of the present invention.
[Fig. 7A] Fig. 7A is a cross-sectional view showing a configuration of a general package.
[Fig. 7B] Fig. 7B is a plan view showing a partial configuration of the general package.

### [Description of Embodiments]

Hereinafter, a package according to an embodiment of the present invention will be described.

### [Embodiment 1]

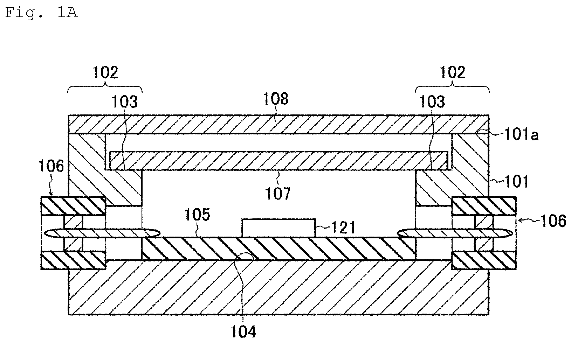

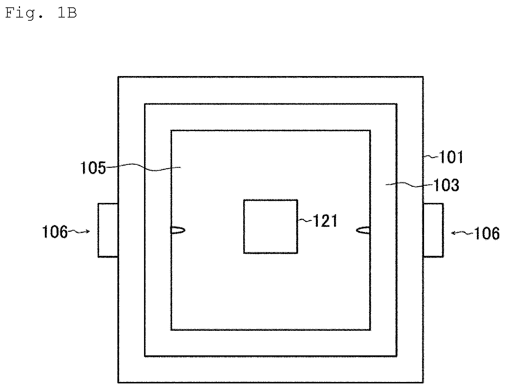

First, a package according to Embodiment 1 of the present invention will be described with reference to Figs. 1A and 1B. The package includes a container 101, an engaging section 103, a dielectric substrate 105, an input/output IF 106, a radio wave absorber 107 and a lid 108.

The container 101 is made of a metal, and is formed into a bottomed cylindrical shape with an upper surface opened. The engaging section 103 is made up of a step that is formed on the opening edge 102 of the container 101 and spreads to the outer peripheral side. The dielectric substrate 105 is disposed on the bottom surface 104 of the container 101, and a device 121 having broadband characteristics is mounted thereon. The device 121 is, for example, a semiconductor device made of a compound semiconductor such as InP.

The input/output IF 106 is provided on a side surface of the container 101, and is connected to the device 121 to achieve transmission/reception of a signal to/from the outside. The radio wave absorber 107 is engaged to the engaging section 103 to cover the whole region of the bottom surface 104 of the container 101. The radio wave absorber 107 has a plate shape. The lid 108 is made of a metal, and closes the opening end 101a of the container 101 to seal the inside of the container 101. The inside (inner cavity) of the container 101 is hermetically sealed by the lid 108. Sealing of the lid 108 can be performed by sealing techniques such as seam welding.

An outer shape of the container 101, an inner shape (bottom surface 104) of the container 101, and shapes of the radio wave absorber 107 and the lid 108 in a plan view can be, for example, rectangular shapes. The outer shape of the container 101, the inner shape (bottom surface 104) of the container 101, and the shapes of the radio wave absorber 107 and the lid 108 in a plan view can be polygons or circles.

According to the package described above, a step extending to the outer peripheral side is formed at the opening edge 102 of the container 101, and the radio wave absorber 107 is disposed on the engaging section 103 by the step. A part of the step on which the engaging section 103 is formed spreads outward from a region (bottom surface 104) in a plan view of a package inner cavity in which the device 121 is accommodated. Therefore, the radio wave absorber 107 can be made wider than the area (bottom surface 104) of the package inner cavity in a plan view. As a result, the radio wave absorber 107 can be provided to cover the whole area of the bottom surface 104 in a plan view. Since the entire upper surface of the package inner cavity (cavity) can be covered with the radio wave absorber 107 in this way, the inner side surface of the lid 108 is not exposed to the package inner cavity, and cavity resonance can be completely suppressed.

### [Embodiment 2]

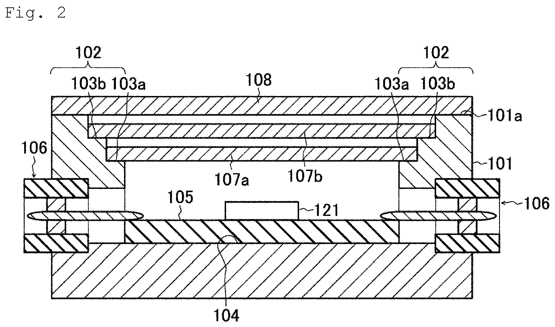

Next, a package according to Embodiment 2 of the present invention will be described with reference to Fig. 2. The container 101, the dielectric substrate 105, the input/output IF 106, and the lid 108 are provided. The configurations of these constituent elements are similar to those described in Embodiment 1.

The package according to Embodiment 2 includes a plurality of first engaging sections 103a and second engaging sections 103b formed by stepped steps extending to the outer peripheral side and formed at the opening edge 102 of the container 101. Further, a plurality of first radio wave absorbers 107a and second radio wave absorbers 107b engaged to each of the first engaging section 103a and the second engaging section 103b are included. The plurality of first radio wave absorbers 107a and second radio wave absorbers 107b have different compositions, dielectric constants and magnetic permeability. The plurality of first radio wave absorbers 107a and second radio wave absorbers 107b have a higher dielectric constant as they are closer to the lid 108.

According to Embodiment 2, the package has a structure in which the dielectric constant changes stepwise from the package inner cavity in which the device 121 is accommodated toward the lid 108, and the radio waves can be absorbed. As a result, it is possible to suppress reflection of the electromagnetic wave at an interface between the radio wave absorber and the space in which the electromagnetic wave enters the radio wave absorber from the package inner cavity (cavity).

### [Embodiment 3]

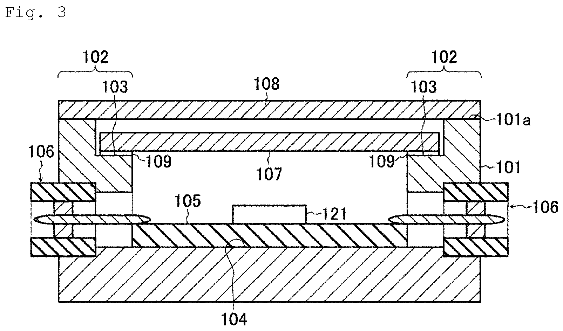

Next, a package according to Embodiment 3 of the present invention will be described with reference to Fig. 3. The package includes a container 101, an engaging section 103, a dielectric substrate 105, an input/output IF 106, a radio wave absorber 107 and a lid 108. The configurations of these constituent elements are similar to those described in Embodiment 1.

The package according to Embodiment 3 further includes an adhesive member 109 that adheres the radio wave absorber 107 to the engaging section 103. The adhesive member 109 can be made of, for example, a brazing material such as a conductive adhesive or a solder material. According to Embodiment 3, the radio wave absorber 107 can be firmly joined to the container 101, and breakage (breakage) of the radio wave absorber 107 can be prevented.

### [Embodiment 4]

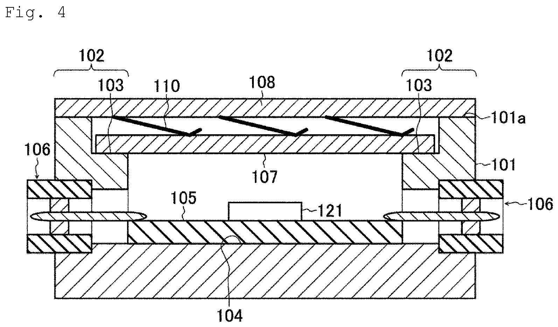

Next, a package according to Embodiment 4 of the present invention will be described with reference to Fig. 4. The package includes a container 101, an engaging section 103, a dielectric substrate 105, an input/output IF 106, a radio wave absorber 107 and a lid 108. The configurations of these constituent elements are similar to those described in Embodiment 1.

The package according to Embodiment 4 further includes a spring member 110 arranged between the lid 108 and the radio wave absorber 107 to press the radio wave absorber 107 against the engaging section 103. The spring member 110 can be made of an elastic material such as a leaf spring, a coil spring, and rubber. According to Embodiment 4, the radio wave absorber can be fixed by physical pressing without using an adhesive member. In addition, the curing process of the adhesive member can be omitted, and the package can be manufactured at a lower cost.

### [Embodiment 5]

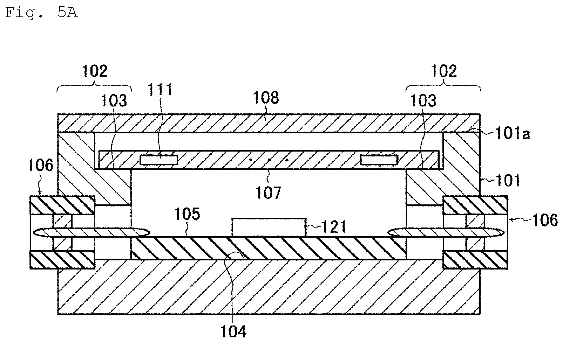

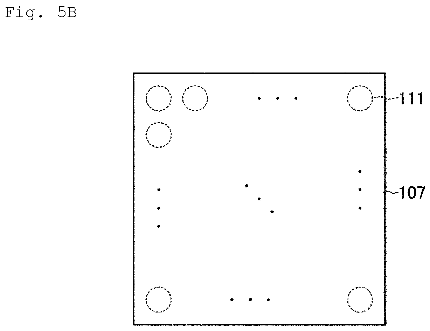

Next, a package according to Embodiment 5 of the present invention will be described with reference to Figs. 5A and 5B. The package includes a container 101, an engaging section 103, a dielectric substrate 105, an input/output IF 106, a radio wave absorber 107 and a lid 108. The configurations of these constituent elements are similar to those described in Embodiment 1.

In Embodiment 5, a plurality of voids 111 are formed in the radio wave absorber 107. Each of the plurality of voids 111 has a thickness of 1/4 of a resonance wavelength of the container 101 calculated from an internal volume of the container 101 sealed by the lid 108. Each of the plurality of voids 111 has an outer shape dimension of 1/10 or less of a resonance wavelength in a plan view. In other words, each of the plurality of voids 111 has an outer shape in a plan view of 1/10 or less of a resonance wavelength. For example, each of the plurality of voids 111 is formed into a circular columnar shape having a radius of 1/10 or less of a resonance wavelength in a plan view. The plurality of voids 111 are arranged at a pitch of a resonance wavelength.

According to Embodiment 5, it is possible to realize a package structure having a radio wave absorption effect with respect to a resonance frequency having particularly strong resonance. It should be noted that even if a plurality of openings (through holes) are formed in the radio wave absorber 107, the same effect as described above can be obtained. When the plurality of openings are provided, each of the plurality of openings has an outer shape dimension of 1/10 or less of a resonance wavelength in a plan view, and can be arranged at a pitch of the resonance wavelength.

Each of the above-described embodiments can be realized in combination with each other. For example, even in a configuration in which a plurality of radio wave absorbers are provided, it is possible to provide an adhesive member for adhering the radio wave absorbers to the engaging section, and to provide a spring member for pressing the radio wave absorbers to the engaging section. Even in a configuration in which a plurality of radio wave absorbers are provided, voids and openings can be provided in each radio wave absorber.

According to the above-described embodiment, the cavity resonance can be suppressed as shown by the solid line in Fig. 7. On the other hand, in the related art (broken line) in which there is a gap even if a radio wave absorber is provided, or in the configuration (dashed line) in which no radio wave absorber is provided, cavity strong vibration occurs.

As described above, according to the present invention, since the engaging section constituted by the step extending to the outer peripheral side is formed at the opening edge of the container and the radio wave absorber is engaged to the engaging section, the entire upper surface of the package inner cavity can be covered with the radio wave absorber. Further, since there is no need to join the radio wave absorber and the lid, the configuration of the present invention can be easily implemented, the manufacturing cost of the lid is suppressed, and the configuration advantageously contributes to cost reduction.

Some or all of the embodiments are also described in the following appendixes, but are not limited to the following.

### [Appendix 1]

A package includes a bottomed cylindrical container having an open upper surface, the container being made of a metal; an engaging section provided by a step formed on an opening edge of the container and extending toward an outer peripheral side; a dielectric substrate disposed on a bottom surface of the container, the dielectric substrate on which a device is mounted; an input/output IF provided on a side surface of the container and connected to the device; a plate-like radio wave absorber engaged to the engaging section so as to cover a whole region of the bottom surface of the container; and a lid made of a metal which closes an opening end of the container and seals the inside of the container.

### [Appendix 2]

The package set forth in Appendix 1, further including an adhesive member that adheres the radio wave absorber to the engaging section.

### [Appendix 3]

The package set forth in Appendix 1, further including a spring member arranged between the lid and the radio wave absorber to press the radio wave absorber against the engaging section.

### [Appendix 4]

The package set forth in one of Appendices 1 to 3, in which the radio wave absorber has a thickness of 1/4 of a resonance wavelength of the container calculated from an internal volume of the container sealed by the lid, and further has a plurality of openings arranged at a pitch of the resonance wavelength with an opening dimension of 1/10 or less of the resonance wavelength.

### [Appendix 5]

The package set forth in any one of Appendices 1 to 4, further including a plurality of the engaging sections formed by stair-like steps formed at an opening edge of the container and extending to an outer peripheral side, wherein a plurality of the radio wave absorbers engaged to each of the plurality of the engaging sections are included, wherein the plurality of radio wave absorbers are each different in compositions, dielectric constants, and permeability, and the plurality of radio wave absorbers have a higher dielectric constant being higher the closer to the lid.

Note that it is clear that the present invention is not limited to the embodiments described above, and that within the technical concept of the present invention, many modifications and combinations can be implemented by those skilled in the art.

### [Reference Signs List]

- 101: Container
- 101a: Opening end
- 102: Opening edge
- 103: Engaging section
- 104: Bottom surface
- 105: Dielectric substrate
- 106: Input/output IF
- 107: Radio wave absorber
- 108: Lid
- 121: Device

## Claims

1. A package comprising:
a bottomed cylindrical container having an open upper surface, the container being made of a metal;
an engaging section provided by a step formed on an opening edge of the container and extending toward an outer peripheral side;
a dielectric substrate disposed on a bottom surface of the container, the dielectric substrate on which a device is mounted;
an input/output IF provided on a side surface of the container and connected to the device;
a plate-like radio wave absorber engaged to the engaging section so as to cover a whole region of the bottom surface of the container; and
a lid made of a metal that closes an opening end of the container and seals the inside of the container.

2. The package according to claim 1, further comprising
an adhesive member that adheres the radio wave absorber to the engaging section.

3. The package according to claim 1, further comprising
a spring member arranged between the lid and the radio wave absorber to press the radio wave absorber against the engaging section.

4. The package according to claim 1,
wherein the radio wave absorber includes a plurality of voids or a plurality of openings, wherein
each of the plurality of voids has a thickness of 1/4 of a resonance wavelength of the container calculated from an internal volume of the container sealed by the lid, and
each of the plurality of voids or each of the plurality of openings is arranged at a pitch of the resonance wavelength with an outer shape dimension of 1/10 or less of the resonance wavelength in a plan view.

5. The package according to any one of claims 1 to 4, comprising:
a plurality of the engaging sections formed by stair-like steps formed at an opening edge of the container and extending to an outer peripheral side,
wherein a plurality of the radio wave absorbers engaged to each of the plurality of the engaging sections are included, wherein
the plurality of radio wave absorbers are each different in compositions, dielectric constants, and permeability, and
the plurality of radio wave absorbers have a higher dielectric constant being higher the closer to the lid.
